# FASCICULE DE BREVET EUROPEEN

(11) **EP 1 358 683 B1**
(45) Date de publication et mention de la délivrance du brevet: **08.08.2007**
(21) Numéro de dépôt: 02701354.9
(22) Date de dépôt: 30.01.2002
(51) Int. Cl.: H01L 31/117, H01L 31/18, C03B 23/02

(54) **PROCEDE ET DISPOSITIF DE FABRICATION D'UN DETECTEUR ELECTRONIQUE EN GAAS POUR LA DETECTION DE RAYONS X POUR L'IMAGERIE**
VERFAHREN UND GERÄT ZUR HERSTELLUNG EINES GAAS-DETEKTORS FÜR RÖNTGENSTRAHL- ERFASSUNG UND BILDAUFNAHME
METHOD AND DEVICE FOR PRODUCING AN ELECTRONIC GAAS DETECTOR FOR X-RAY DETECTION FOR IMAGING

(30) Priorité: 31.01.2001 FR 0101337
(43) Date de publication de la demande: 05.11.2003
(73) Titulaire: UNIVERSITE PIERRE ET MARIE CURIE, 75252 Paris Cédex 05 (FR)
(72) Inventeur: BOURGOIN, Jacques, F-77810 Thomery (FR)
(74) Mandataire: Michelet, Alain
(86) Numéro de dépôt international: PCT/FR2002/000362
(87) Numéro de publication internationale: WO 2002/061852

(56) Documents cités:
- US-A- 5 725 659
- US-A- 5 733 815
- OWENS A ET AL: "The hard X-ray response of epitaxial GaAs detectors" NUCLEAR INSTRUMENTS & METHODS IN PHYSICS RESEARCH, SECTION - A: ACCELERATORS, SPECTROMETERS, DETECTORS AND ASSOCIATED EQUIPMENT, NORTH-HOLLAND PUBLISHING COMPANY. AMSTERDAM, NL, vol. 442, no. 1-3, mars 2000 (2000-03), pages 360-363, XP004193517 ISSN: 0168-9002
- BATES R L ET AL: "Development of low-pressure vapour-phase epitaxial GaAs for medical imaging" NUCLEAR INSTRUMENTS & METHODS IN PHYSICS RESEARCH, SECTION - A: ACCELERATORS, SPECTROMETERS, DETECTORS AND ASSOCIATED EQUIPMENT, NORTH-HOLLAND PUBLISHING COMPANY. AMSTERDAM, NL, vol. 434, no. 1, 11 septembre 1999 (1999-09-11), pages 1-13, XP004179219 ISSN: 0168-9002

## Description

La présente invention concerne un procédé de fabrication d'un détecteur électronique en GaAs pour la détection de rayons X pour l'imagerie médicale et l'imagerie pour certaines applications industrielles (ex: examen des bagages d'aéroport).

Il existe deux catégories de détecteurs de photons X en plus de la plaque photographique. La première met en oeuvre une couche photosensible (par exemple, phosphore) qui transforme les photons X en photons visibles, lesquels sont ensuite détectés par les techniques applicables à ces derniers. La seconde utilise des matériaux semiconducteurs qui transforment directement les photons X en électrons, permettant une acquisition directe de l'image sous forme digitale. Ces derniers détecteurs ont de nombreux avantages par rapport aux couches photosensibles. Ils permettent l'acquisition d'images à une cadence plus rapide et présentent des performances (efficacité de collection ou sensibilité, bruit, dynamique, vitesse d'acquisition) supérieures. Actuellement, le seul matériau semi-conducteur ayant des propriétés électroniques adaptées et l'épaisseur nécessaire (quelques 100 µm pour absorber les photons X efficacement) est CdTe. Mais du fait de la faible taille des cristaux disponibles, la mise en oeuvre de ce matériau pour faire de l'imagerie X n'est pas possible au niveau industriel.

On connaît actuellement une nouvelle génération de détecteurs électroniques grande surface pour l'imagerie médicale. Elle utilise un scintillateur (iodure de césium), transformant les photons X en photons visibles, qui sont ensuite détectés par une matrice de pixels photoconducteurs réalisées sur une couche de Si amorphe (a-Si) (General Electric, Canon, Trixell). Le rendement global n'est pas optimal. Ces détecteurs ne permettent qu'une réduction de l'ordre d'un facteur 5 de la : dose d'irradiation du patient en comparaison avec la plaque photographique. Pour approcher, les limites de la détection de photon X et faire de l'imagerie, il faut un matériau semiconducteur qui satisfasse les conditions suivantes:
- matériau de grande taille, ayant un grand numéro atomique Z
- matériau peu cher pour lequel il existe une technologie microélectronique bien maîtrisée,
- matériau de bonne qualité, i.e. contenant peu de pièges et de défauts repartis de façon uniforme.

CdTe et InP ne remplissent pas un ou plusieurs de ces critères et ne conviennent donc pas. Reste GaAs non pas sous forme massive (i.e, obtenu par croissance Czochralski (Cz) ou Vertical gradient freeze (VGF refroidissement par gradient vertical) car il contient alors trop de pièges répartis de façon inhomogène. Seul reste GaAs obtenu par croissance épitaxiale qui peut être relativement pur et a des propriétés électroniques très uniformes.

Il existe par ailleurs des techniques de croissance épitaxiales bien au point VPE (" Vapor Phase Epitaxy" - Epitaxie en phase vapeur), CVD ("Chemical Vapor Déposition" - Epitaxie par décomposition chimique en phase vapeur). Avec ces techniques, les couches épitaxiales sont alors obtenues par le transport de gaz, contenant les éléments constitutifs de la couche à former, jusqu'à un substrat où ils sont décomposés et réagissent avec la surface. Le facteur limitant la croissance du film étant le transport desdits gaz jusqu'au substrat, la vitesse de croissance est lente (~1 à 5 µm par heure) et de très larges volumes de gaz sont nécessaires pour obtenir une couche épaisse (plusieurs centaines de µm). Par conséquent, outre l'aspect onéreux, grands volumes desdits gaz nécessaires, prix du réacteur, temps de fonctionnement, récupération et destruction des gaz résiduels, ces techniques présentent des risques certains inhérents à la nature des gaz employés, pour les personnes et l'environnement.

Ces techniques permettent l'obtention de couches présentant une bonne homogénéité d'ensemble des propriétés électriques qui, ainsi obtenus présentent toutes les caractéristiques nécessaires pour l'obtention de bons détecteurs (Owens et al. [J. Appl. Phys.; 86 (1999) 4341]) mais le taux de croissance est faible (au mieux, 5 µm.h⁻¹) et ne permet donc pas d'obtenir des couches suffisamment épaisses pour absorber efficacement les photons X dans des conditions raisonnables de production industrielle.

Le document A. Owens et al., Nuclear Instruments & Methods in Physics Research, Section A, vol. 442, n°1-3, 360-363 (2000) décrit un procédé de fabrication d'un détecteur en GaAs. Le document US 5,725,659 décrit un autre procédé de fabrication d'un dispositif en GaAs.

L'objectif de la présente invention est donc de proposer un procédé et un dispositif simple dans sa conception et dans son mode opératoire, non polluant, rapide et économique pour la réalisation de détecteurs électroniques utilisant des couches épitaxiales de GaAs, utilisables pour la détection de rayons X en particulier pour l'imagerie.

A cet effet, l'invention concerne un procédé de fabrication d'un détecteur électronique en GaAs pour la détection de rayons X pour l'imagerie comme décrit dans la revendication 1.

Les revendications 2-6 définissent des réalisations particulièrement advantageuses.

L'invention concerne également un dispositif de fabrication d'un détecteur électronique en GaAs pour la détection de rayons X pour l'imagerie comme décrit dans la revendication 7.

Les revendications 8-10 définissent des réalisations particulièrement advantageuses.

Le détecteur ainsi réalisé peut être utilisé seul pour la détection de photons X d'énergie comprise entre 20 et 60 keV. Ce détecteur peut également être utilisé pour des énergies de photons X supérieures mais le plus faible coefficient d'absorption de GaAs pour ces énergies en réduit la sensibilité. Il peut avantageusement être mis en oeuvre pour l'imagerie médicale et certaines applications industrielles (par exemple: examen de bagages d'aéroport).

L'invention sera décrite plus en détail en référence aux dessins annexés dans lesquels:
- la figure 1 est une représentation schématique des étapes successives 1a), 1b), 1c), 1d), 1e), 1f) et 1g) conduisant à la réalisation d'un détecteur de rayons X, selon l'invention;
- la figure 2 est une représentation schématique du dispositif de croissance de couches épitaxiales, selon l'invention;

Une des conditions requises pour l'application de détecteurs électroniques à l'imagerie, est que la dimension du matériau semiconducteur sur lequel les détecteurs sont réalisés soit suffisamment grande. Or, l'obtention de couches épitaxiales de grande taille est liée à l'existence de barreaux monocristallins de grand diamètre dans lesquels des substrats de bonne qualité cristallographique peuvent être découpés. En outre, ces couches doivent être réalisées avec des matériaux à grand numéro atomique Z (i.e. ceux pour lesquels l'absorption des photons X est importante: InP, CdTe, GaAs), à savoir ceux pour lesquels de larges cristaux existent. Parmi ces matériaux, GaAs permet d'obtenir des substrats pouvant atteindre jusqu'à quinze centimètres de diamètre. Les cristaux de CdTe n'existent qu'en dimension plus petite (quelques centimètres de diamètre) et ceux de InP sont des cristaux moyens, de l'ordre de 5 cm de diamètre. Le GaAs présente l'avantage, outre ses propriétés intrinsèques plus ou moins communes avec InP et CdTe (bande interdite de 1,4 eV, bon coefficient d'absorption jusqu'à au moins 60 keV, forte mobilité des porteurs de charge) que les technologies de la microélectronique pour ce matériau sont déjà standardisées dans l'industrie. Le matériau retenu pour la croissance des couches épitaxiales est donc GaAs.

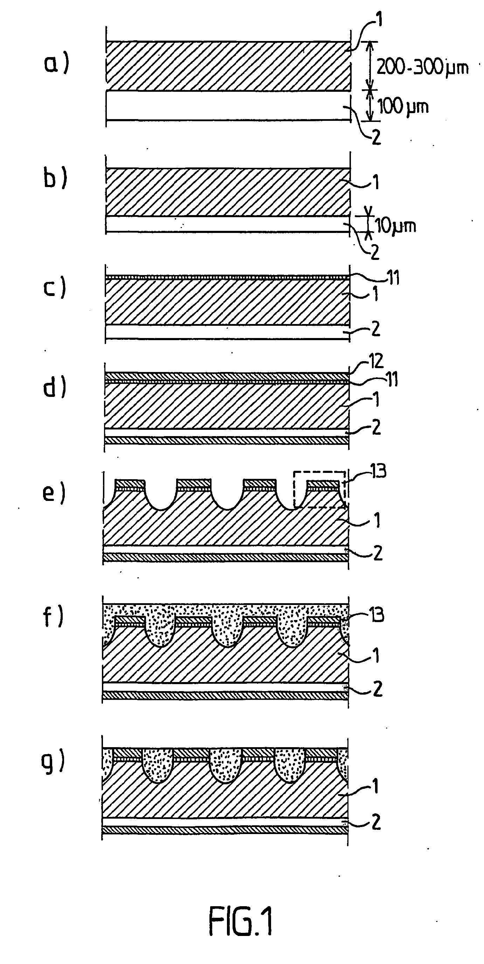

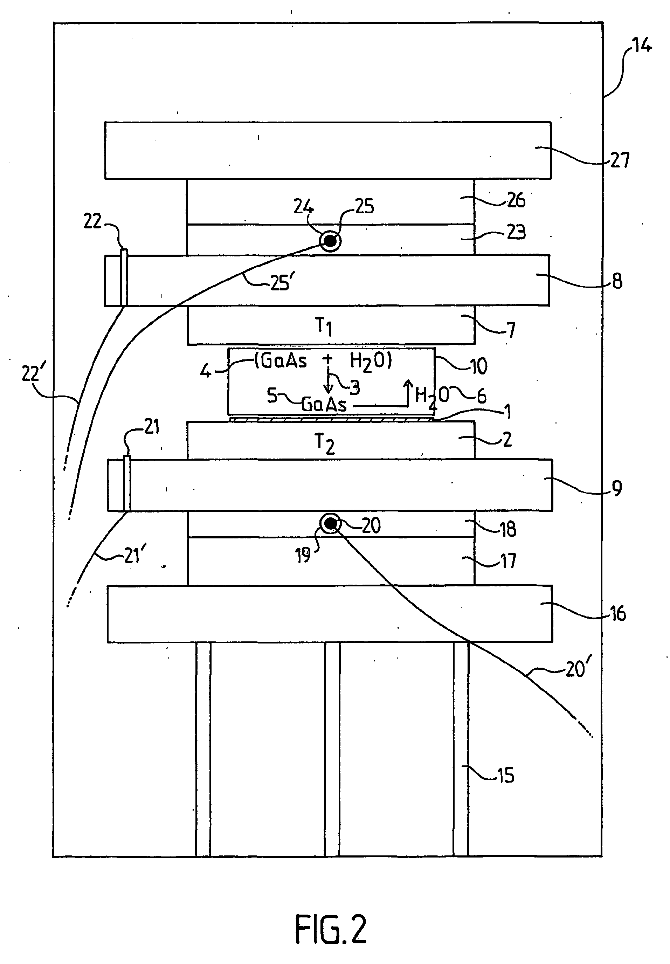

Selon l'invention telle que représentée sur la figure 1, le procédé conduisant à la fabrication de détecteurs de rayons X en GaAs comporte les étapes successives suivantes. La première étape 1a) consiste en la croissance de couches épitaxiales 1 d'épaisseur d' dépendant de l'énergie des photons à détecter sur un substrat n⁺ (ou p⁺) 2. Le matériau déposé 1 ne résulte pas de l'utilisation d'une technique conventionnelle de croissance de couches épitaxiales (VPE ou CVD). En effet, avec ces dernières, le facteur limitant la croissance de la couche 1 est le transport des gaz, contenant les éléments constitutifs de la couche à former sur le substrat 2. Le taux de croissance reste donc faible (au mieux, 5 µm.h⁻¹). Or, la détection de photons X nécessite la croissance de couches épitaxiales 1 d'épaisseur 100 µm, au minimum. Les techniques conventionnelles ne permettent donc pas d'obtenir, en un temps raisonnable, la croissance d'une couche épitaxiale 1 suffisamment épaisse pour absorber efficacement les photons X. La croissance du matériau épitaxial 1 résulte donc d'une méthode visant à supprimer le transport des gaz jusqu'au substrat 2 pour obtenir un taux de croissance plus rapide. Selon l'invention et la figure 2a), le taux 3 avec lequel le matériau est transporté de la source 1 jusqu'au substrat n⁺ (ou p⁺) 2 n'est plus alors fonction que des vitesses des réactions chimiques entre les matériaux source 4, substrat 5 et le gaz réactif 6. Pour cela, un matériau source 7 ayant la même composition chimique, que le matériau 1 à faire croître (GaAs), donc non intentionnellement dopé et donc dit semi-isolant est porté à une température T₁ > 600°C (préférentiellement comprise entre 750 et 850°C) par une chaufferette 8. Ladite chaufferette 8 est constituée d'une résistance métallique recouverte de nitrure de bore mais peut être de nature différente (ruban de graphite, etc ...) tant qu'il limite au maximum la pollution de la couche à faire croître par des impuretés. Le gaz réactif 6, H₂O, sous une pression partielle de 500 à 600 ppm interagit chimiquement avec le matériau source 7 porté à la température T₁ en créant des produits volatiles. Ces composés volatiles sont transportés par le gradient de pression 3 jusqu'à un substrat n⁺ (ou p⁺) 2 porté à une température T₂ < T₁ ( avantageusement inférieure d'au moins 50°C) par la chaufferette 9 identique à la première: Les produits volatiles recomposent alors à la surface du substrat n⁺ (ou p⁺) 2 pour reformer GaAs 5 et H₂O gazeux 6. Ce dernier est alors de nouveau disponible pour participer au processus réactionnel. Il s'agit d'un système fermé : il n'est donc pas besoin d'avoir un apport continu de gaz réactif; ni même d'hydrogène. Un anneau en quartz, nitrure de bore ou graphite 10, d'épaisseur d comprise entre 1 et 2 mm pour un substrat d'environ 5 cm de diamètre φ sépare le substrat n⁺ (ou p⁺) 2 du matériau source 7 et assure leur isolation thermique. Lorsque la taille du substrat est plus importante, il faut augmenter d (d est de l'ordre de 3-4 mm pour φ = 10 cm).

A cause de la différence de température relativement faible entre le matériau source 7 et le substrat 2, imposée par la courte distance séparant lesdits éléments, la croissance de couche épitaxiale 1 s'effectue dans des conditions proches de l'équilibre réactionnel entre le cristal et le gaz réactif. Puisque le système est clos par l'anneau 10, le rapport respectif des pressions des produits volatiles issus des réactions chimiques est tel que les conditions stoechiométriques sont maintenues. Ainsi lors de la décomposition de GaAs 4 par H₂O 6 donnée par l'équation suivante:

GaAs (s) + H₂O (g) → Ga₂O (g) + AS₂ (g) + H₂ (g)

il existe une relation directe entre la pression de Ga₂O et As₂. Il n'est donc pas nécessaire d'introduire une pression supérieure de As₂ (g) par rapport à celle de Ga₂O (g) comme dans les techniques de croissance de couches épitaxiales.

La vitesse de croissance des couches épitaxiales 1 n'est, ici, fonction que des températures respectives, T₁ et T₂, du matériau source 7 et du substrat n⁺ (ou p⁺) 2, de la pression partielle p du gaz réactif 6.

Le matériau source est non intentionnellement dopé: il contient des dopants de type p et n en concentration 10¹⁵ - 10¹⁶ cm⁻³ qui sont respectivement principalement C et Si d'après la littérature. Le matériau obtenu contient donc aussi ces impuretés mais dans des proportions différentes car le transport des impuretés dépend de la nature de celles-ci.

Après, croissance de la couche épitaxiale 1, on diminue l'épaisseur du substrat 2 par polissage mécano-chimique (étape 2, Fig. 1b)) pour ramener son épaisseur à environ à 10 µm. Dans une troisième étape (Fig. 1c)), on implante des ions Hg⁺ ou Be⁺, respectivement Si⁺, avec des énergies comprises entre 10 et 200 keV (avantageusement autour de 100 keV) et des doses typiques (de l'ordre de 10¹⁴ atomes/cm²) pour former une couche 11 contrôlée en dopage (supérieur à 10¹⁸ cm⁻³) de type p⁺, respectivement n⁺. Cette implantation est suivie d'un recuit thermique rapide à une température (environ 850 °C) et pendant un temps court déterminé (10s). On a ainsi fabriqué une jonction p⁺/i/n⁺. On réalise ensuite des contacts ohmiques 12 (étape 4, Fig. 1d)) sur les deux faces par évaporation d'un alliage à base d'or, suivi d'un recuit à une température de l'ordre de 400°C et pendant un temps déterminé (300s). Cet alliage est par exemple AuGe ou NiAu pour les contacts n⁺ et TiPtAu ou AuZn pour les contacts p⁺. Cette étape est suivie d'un masquage par photolithographie, décapage chimique (étape 5, Fig. 1e)) pour former des pixels.

Ces pixels 13 fabriquées par lithographie sont des surfaces en général de 50 à 150 µm carré (pour les applications médicales) faites sur une face ou des lignes de la même dimension sur chacune des faces en quadrature (Fig. 1e)). Ces étapes sont complétées par une passivation des surfaces décapées (par dépôt de nitrure de silicium, par exemple (étape 6, Fig. 1f)) suivie d'une ouverture sur les pixels par un nouveau décapage après photolithographie (étape 7. Fig. 1g)) pour prendre les contacts.

Dans un mode de réalisation préféré, le dopage résiduel du matériau épitaxial 1 est réduit de façon à augmenter la largeur W de la charge d'espace pour qu'elle occupe toute l'épaisseur de la couche. En effet, le dopage résiduel peut être tel que la tension maximale Vₘ applicable, (i.e. la tension de claquage), ne soit pas suffisante pour obtenir la déplétion complète de la structure. Par exemple, une couche possédant initialement 1 x 10¹⁴ cm⁻³ dopants résiduels ne pourra subir une déplétion que sur une zone atteignant W = 23 µm pour une tension de 40 V. Donc si la couche a une épaisseur de 100 µm seul un quart de celle-ci sera actif. La solution, selon l'invention, consiste alors à introduire des défauts dans la couche en concentration uniforme pour piéger les porteurs résiduels. Une des façons d'introduire ces défauts consiste à irradier de façon uniforme par l'intermédiaire d'une source à électrons de 1 MeV environ la surface entière du matériau. Dans notre exemple ci-dessus, l'introduction d'une concentration de défauts de 10¹⁴ cm⁻³ par cette irradiation permet de compenser totalement les dopants résiduels et donc d'obtenir une déplétion sur toute l'épaisseur de la couche. Pour une introduction minimale de défauts de façon à avoir un impact négligeable sur les performances du détecteur, on mesurera la capacité d'un des pixels du détecteur en fonction de la dose d'irradiation de façon à arrêter celle-ci dès que la valeur la capacité est égale à celle de l'épaisseur de la coucher (1).

Cette irradiation pourra se faire une fois le détecteur fini ou même monté et connecté à son électronique.

L'invention concerne également un dispositif de fabrication d'un détecteur électronique en GaAs pour la détection de rayons X pour l'imagerie. Selon l'invention et la figure 2, ce dispositif comprend une enceinte 14 en acier inoxydable, au sein duquel sont disposés des moyens de croissance de couches. Cette enceinte comprend un ensemble de connections permettant d'introduire l'hydrogène purifié après avoir fait le vide et d'évacuer à la fin du dépôt, les réactifs chimiques issus de la décomposition de GaAs 4 par H₂O 6 afin de les traiter. L'évacuation et le vide sont réalisés à l'aide d'une pompe primaire. Cette enceinte 14 comprend également un ensemble de connections permettant de réaliser des contacts électriques entre les sources d'alimentation en courant, les jauges de lecture de températures et l'intérieur du dispositif.

Les moyens de croissance de couches sont portés par un trépied 15 constitué de k pieds en inox (avec k ≥ 3). Ce trépied permet d'isoler thermiquement l'enceinte 14 du reste du dispositif Sur ce trépied 15, est montée une première plaque en inox 16 servant de base pour les moyens de croissance. Ces moyens de croissance comprennent une première plaque en quartz 17 qui permet d'isoler thermiquement la base en inox 16 des moyens de chauffage. Ces moyens de chauffage comprennent une première chaufferette 8 alimentée en courant par des connections 21. Ladite chaufferette 8 est constituée d'une résistance métallique recouverte de nitrure de bore. Une première .plaquette en inox 18 d'épaisseur de l'ordre du millimètre permet la mesure de la température de la chaufferette 8. Cette mesure de température commande la régulation en température du dispositif. La plaquette 18 comprend un conduit 19 pour y insérer des moyens de mesure en température, un thermocouple par exemple, 20. La première chaufferette 8 permet de porter à une température T₂ > 600°C, un substrat n⁺ (ou p⁺) 2. Sur ce substrat est posé un anneau 10, inerte dans les conditions expérimentales décrites (i.e. Tᵢ > 600°C où i = 1,2) et d'épaisseur d de l'ordre de quelques millimètres. Il sépare et isole thermiquement le substrat ri (ou p⁺) 2 d'un matériau source 7. Afin d'éviter des conditions de dépôt non uniforme, le parallélisme du matériau source 7 et du substrat n⁺ (ou p⁺) 2 est assuré par l'anneau inerte 10 à mieux que 0,1 mm prés. L'anneau inerte 10, anneau en quartz, nitrure de bore ou graphite, assure également la perméabilité gazeuse entre l'espace où siègent les réactions et l'atmosphère interne au dispositif, H₂ purifié sous une pression de l'ordre de l'atmosphère et H₂O 6 sous une pression partielle p de l'ordre de 300 à 900 ppm selon la vitesse de croissance désirée. Comme l'anneau inerte 10 n'assure pas une étanchéité parfaite, H₂O 6 et H₂ purifiés peuvent passer.

Une seconde chaufferette 9 alimentée en courant 22 permet de porter le matériau source 7 à une température T₁ > T₂. La différence de température entre T₁ et T₂ est préférentiellement supérieure à 50°C. Une seconde plaquette en inox 23 d'épaisseur de l'ordre du millimètre comprenant un conduit 24 pour y recevoir moyens de mesure en température 25, un thermocouple par exemple, permet de vérifier la température de la seconde chaufferette 9, Les cordons d'alimentation et de mesure 20', 21', 22' et 25' se référent aux éléments du dispositif portant le numéro correspondant. Une seconde plaque en quartz 26 est posée sur la plaquette en inox 23 et sert à isoler thermiquement une seconde plaque en inox 27 et l'enceinte 14 des moyens de chauffage. Cette seconde plaque en inox 27 de part le poids qu'elle exerce, favorise également des conditions de dépôt uniforme en assurant un contact étroit entre l'anneau inerte 10, le substrat n⁺ ou p⁺ 2 et le matériau source 7 lors du chauffage.

Ce procédé peut avantageusement être utilisé pour la fabrication de détecteurs utilisant GaAs puisque ce matériau est particulièrement performant dans la gamme d'énergie: 20-60 keV. Cette gamme d'énergie est adaptée en particulier pour l'imagerie médicale (mammographies, soins dentaires, ...) et certaines applications industrielles (exemple: examen des bagages d'aéroport). Pour l'imagerie médicale, le détecteur décrit devrait conduire à une diminution de la dose d'irradiation X d'un facteur 10 par rapport aux techniques conventionnelles. On peut prévoir également une meilleure résolution et une plus grande dynamique (Owens et al. [J. Appl. Phys.; 86 (1999) 4341]) permettant ainsi une amélioration du contraste de l'image et une augmentation du nombre de teintes. La vitesse d'acquisition de l'image devrait aussi être très rapide par rapport aux dispositifs avancés actuels.

## Revendications

1. Procédé de fabrication d'un détecteur électronique en GaAs pour la détection de rayons X pour l'imagerie, dans lequel on fait d'abord croître une couche épitaxiale sur un substrat n⁺ (ou p⁺) pour former un matériau semiconducteur comportant un certain dopage résiduel, ladite étape de croissance de ladite couche épitaxiale, durant tant que l'épaisseur de la couche épitaxiale résultante n'est pas suffisante pour absorber efficacement les photons X, comporte les étapes consistant :
- à assurer le parallélisme et l'isolation thermique entre le substrat n⁺ (or p⁺) et le matériau source, ledit matériau source étant une plaquette découpée dans un lingot de GaAs semi-isolant non intentionnellement dopé, ledit matériau source et ledit matériau semiconducteur étant de même nature ;
- à chauffer ledit matériau source à une première température T₁>600°C;
- à chauffer ledit substrat n⁺ (or p⁺) à une seconde température T₂ , ladite seconde température T₂ étant inférieure à ladite première température T₁;
- à faire interagir chimiquement un gaz réactif avec le matériau source de température T₁ pour créer des produits volatils ;
- à transporter lesdits produits volatils vers ledit substrat n⁺ (or p⁺) au moyen d'un gradient de pression entre ledit matériau source à la température T₁ et ledit substrat n⁺ (or p⁺) à la température T₂;
- à faire interagir chimiquement lesdits produits volatils à la surface dudit substrat n⁺ (or p⁺) à la température T₂ de manière à recomposer ledit gaz réactif et ledit matériau semiconducteur,
le procédé de fabrication se poursuivant par les étapes consistant à :
- on diminue l'épaisseur du substrat par polissage mécano-chimique, on forme une structure p⁺/i/n⁺ en implantant des ions p⁺ (or n⁺) sur une face externe du matériau semiconducteur, on recuit ladite structure p+/i/n⁺ à une température θ₁ pendant un temps t₁,
- on réalise des contacts ohmiques sur les deux faces de la structure p⁺/i/n ⁺
- on réalise des détecteurs individuels par masquage, passivation et décapage, ohmique ;
ledit procédé comportant également une étape consistant à réduire le dopage résiduel de ladite couche épitaxiale.

2. Procédé selon la revendication 1, **caractérisé en ce qu'**on réalise les contacts ohmiques (12) par évaporation d'un alliage à base d'or suivi d'un recuit.

3. Procédé selon les revendications 1 et 2, **caractérisé en ce qu'**on réduit le dopage résiduel par irradiation uniforme avec des électrons de 1 MeV environ et à une dose ajustée de la façon suivante : on mesure la capacité d'un détecteur individuel en fonction de la dose et on arrête l'irradiation lorsque la capacité est égale à celle de l'épaisseur de la couche (1).

4. Procédé selon l'une quelconque des revendications 1 à 3, **caractérisé en ce que** l'épaisseur d' de la couche dépend de l'énergie des photons X à absorber et qu'elle est comprise entre 100 µm et 1 mm.

5. Procédé selon l'une quelconque des revendications 1 à 4, **caractérisé en ce que** le gaz réactif (6) est H₂O sous une pression partielle de plusieurs centaines de ppm,

6. Procédé selon l'une quelconque des revendications 1 à 5, **caractérisé en ce que** la croissance a lieu sous atmosphère d'hydrogène purifié de l'ordre de la pression atmosphérique,

7. Dispositif de fabrication d'un détecteur électronique en GaAs pour la détection de rayons X pour l'imagerie comprenant :
- une enceinte (14),
- k pieds (avec k ≥ 3) pieds formant un trépied (15) et isolant thermiquement l'enceinte (14) du reste du dispositif,
- une première plaque (16) montée sur le trépied (15) et servant de base au reste du dispositif,
- une première plaque inerte (17) servant à isoler thermiquement la base (16) des moyens de chauffage,
- une première plaquette (18) comprenant un conduit (19) pour y recevoir des moyens de mesure en température (20),
- des moyens de chauffage comprenant une première chaufferette (8) alimentée en courant (21) et portant à une température T₂ > 600°C, un substrat n⁺ (ou p⁺) (2),
- un anneau inerte (10) d'épaisseur d de l'ordre de quelques millimètres, séparant et isolant thermiquement le substrat n⁺ (ou p⁺) (2) et un matériau source (7),
- une seconde chaufferette (9) alimentée en courant (22) et portant le matériau source (7) à une température T₁ > T₂,
- une seconde plaquette (23) comprenant un conduit (24) pour y recevoir des moyens de mesure en température (25),
- une seconde plaque inerte (26) servant à isoler thermiquement une seconde plaque (27) du reste du dispositif,

8. Dispositif selon la revendication 7, **caractérisé en ce que** le parallélisme du matériau source (7) et du substrat n⁺ (ou p⁺) (2) est assuré à mieux que 0,1 mm prés par l'anneau inerte (10) d'épaisseur d de l'ordre de quelques millimètres,

9. Dispositif selon les revendications 7 et 8, **caractérisé en ce que** l'anneau inerte (10) permet la perméabilité gazeuse entre l'espace où siègent les réactions et l'atmosphère interne au dispositif, H₂ purifié contenant H₂O (6) à une pression contrôlée.

10. Dispositif selon l'une quelconque des revendications 7 à 9, **caractérisé en ce que** l'enceinte (14) est évacuée par une pompe (28) avant introduction d'H₂ purifié et après dépôt de la couche épitaxiale afin de filtrer les produits issus de la réaction (6).

## Claims

1. A method for producing an electronic GaAs detector for X-ray detection for imaging wherein:
- a method for growing epitaxial layer on a substrate n⁺ (or p⁺) is used in order to form a semiconductor material having a certain residual doping,said growing step of said epitaxial layer is made as long as the resulting epitaxial layer thickness is not sufficient in order to absorb efficiently the X photons, and comprising the steps of :
- providing parallelism and thermal insulation between the substrate n+ (or p+) and a source material, said source material being a wafer cut into a semi-isolating GaAs in got unintentionally doped, said source material and said semiconductor material being of the same kind,
- heating said source material to a first temperature T₁ > 600°C,
- heating said substrate n+ (or p+) to a second temperature T₂, said second temperature T₂ being less than said first temperature T₁,
- interacting chemically a reactive gas with the source material of temperature T₁ in order to create volatile products,
- moving said volatile products towards said substrate n+ (or p+) by means of a pressure gradient between said source material of temperature T₁ and said substrate n+ (or p+) of temperature T₂,
- interacting chemically said volatile products at the surface of said substrate n+ (or p+) of temperature T2 in order to recompose said reactive gas and said semiconductor material, the method for producing comprising moreover the steps of :
- reducing the thickness of the substrate by mechanical-chemical polishing, forming a p+/i/n+ structure by implantation of p+ (or n+) ions on an external face of the semiconductor material, annealing said p+/i/n+ structure at a temperature θ₁ during the time t₁,
- making ohmic contacts on both faces of p+/i/n+ structure,
- making individual detectors by masking, passivation and ohmic pickling,
said method comprising also a step consisting in reducing the residual doping of said epitaxial layer.

2. A method according to claim 1, **characterised in that** the ohmic contacts (12) are produced by evaporation of a gold-based alloy, followed by annealing.

3. A method according to claims 1 and 2, **characterised in that** the residual doping is reduced by uniform irradiation with approx. 1 MeV electrons and at a dose adjusted as follows: the capacity of an individual detector is measures according to the dose and the irradiation is stopped when the capacity is equal to that of the thickness of the layer (1).

4. A method according to anyone of claims 1 to 3, **characterised in that** the thickness d' of the layer depends on the energy of the X photons to be absorbed, but it ranges between 100 µm and 1 mm,

5. A method according to anyone of claims 1 to 4, **characterised in that** the reactive gas (6) is H₂O under partial pressure of several hundred ppm.

6. A method according to anyone of claims 1 to 5, **characterised in that** the growth is performed under purified hydrogen atmosphere, substantially of the atmospheric pressure.

7. A device for producing an electronic GaAS detector for X-ray detection for imaging comprising:
- a chamber (14),
- k feet (with k ≥ 3) forming a tripod (15) and insulating the chamber (14) thermally from the remainder of the device,
- a first plate (16) mounted on the tripod (15) and serving as a base for the remainder of the device,
- a first inert plate (17) serving for thermal insulation of the base (16) of the heating means,
- a first wafer (18) comprising a duct (19) in order to accommodate therein temperature measuring means (20),
- heating means comprising a first power (21) supplied heater (8) and heating a substrate n⁺ (or p⁺) (2) to a temperature T₂ > 600°C,
- an inert ring (10) of thickness d of about few millimetres, separating and insulating the substrate n⁺ (or p⁺) (2) and a source material (7) thermally,
- a second power (22) supplied heater (9) heating the source material (7) to a temperature T₁ > T₂,
- a second wafer (23) comprising a duct (24) in order to accommodate therein temperature measuring means (25),
- a second inert plate (26) serving for thermal insulation of a second plate (27) from the remainder of the device.

8. A device according to claim 7, **characterised in that** the parallelism of the source material (7) and of the substrate n⁺ (or p⁺) (2) is ensured in excess of within 0.1 mm by the inert ring of thickness d of about few millimetres,

9. A device according to claims 7 and 8, **characterised in that** the inert ring (10) enables gaseous permeability between the space where the reactions take place and the internal atmosphere of the device, H₂ purified containing H₂O (6) at controlled pressure.

10. A device according to anyone of claims 7 to 9, **characterised in that** the chamber (14) is evacuated by a pump (28) before introduction of purified H₂ and after deposition of the epitaxial layer in order to filter the products derived from the reaction (6).

## Patentansprüche

1. Verfahren zur Herstellung eines elektronischen GaAs-Detektors zur Röntgenstrcihlenerfassung und Bildaufnahme, wobei zunächst eine Epitaxieschicht auf einem Substrat n⁺ (oder p⁺) gezüchtet wird, um ein Halbleitermaterial zu bilden, das eine gewisse Restdotiersubstanz umfasst, wobei der Schritt des Züchtens der Epitaxieschicht, in der die Dicke der anfallenden Epitaxieschicht nicht ausreicht, um die Röntgenphotonen wirksam zu absorbieren, die Schritte umfasst, welche bestehen aus:
- Gewährleisten der Parallelität und der thermischen Isolierung zwischen dem Substrat n⁺ (oder p⁺) und dem Ausgangsmaterial, wobei das Ausgangsmaterial ein Wafer ist, der in einen Block (Ingot) aus halbisolierendem GaAs, das unbeabsichtigt dotiert ist, geschnitten ist, wobei das Ausgangsmaterial und das Halbleitermaterial dieselbe Beschaffenheit aufweisen;
- Erhitzen des Ausgangsmaterials auf eine erste Temperatur T₁> 600 °C;
- Erhitzen des Substrats n⁺ (oder p⁺) auf eine zweite Temperatur 12. wobei die zweite Temperatur T₂ kleiner ist als die erste Temperatur T₁;
- chemisches Interagieren lassen eines Reaktionsgases mit dem Ausgangsmaterial mit der Temperatur T₁, um flüqhtige Produkte zu kreieren;
- Transportieren der flüchtigen Produkte zum Substrat n⁺ (oder p⁺) mittels eines Druckgradienten zwischen dem Ausgangsmaterial mit der Temperatur T₁ und dem Substrat n⁺(oder p⁺) mit der Temperatur T₂;
- chemisches Interagieren lassen der flüchtigen Produkte an der .Oberfläche des Substrats n⁺ (oder p⁺) mit der Temperatur T₂, so dass das Reaktionsgas und das Halbleitermaterial zusammengesetzt werden,
wobei sich das Herstellungsverfahren durch folgende Schritte fortsetzt, die bestehen aus:
- Verringern der Dicke des Substrats durch mechanischchemisches Polieren, Bilden, einer Struktur p⁺/i/n⁺ durch das Implantieren der Ionen p⁺ (oder n⁺) auf einer Außenseite des Halbleitermaterials, Tempern der Struktur p⁺/i/n⁺ auf eine Temperatur θ₁ während einer Zeitdauer t₁,
- Erstellen der galvanisch leitenden Verbindungen (ohmsche Leiter) auf den beiden Seiten der Struktur p⁺/i/n⁺,
- Erstellen der einzelnen Detektoren durch Maskierung, Passivierung und ohmsches Beizen;
wobei dieses Verfahren auch einen Schritt umfasst, der aus dem Reduzieren der Restdotiersubstanz der Epitaxieschicht besteht.

2. Verfahren nach Anspruch 1, **dadurch gekennzeichnet, dass** das Verwirklichen der galvanisch leitenden Verbindungen (12) durch Verdampfung einer Legierung auf Goldbasis, gefolgt von Tempern durchgeführt wird.

3. Verfahren nach Ansprüchen 1 und 2, **dadurch gekennzeichnet, dass** die Restdotiersubstanz durch einheitliche Bestrahlung mit ungefähr 1 MeV Elektronen und bei einer Dosis, die wie folgt angepasst ist, reduziert wird: die Kapazität eines einzelnen Detektors wird nach der Dosis und die Bestrahlung wird angehalten, wenn die Kapazität derjenigen der Dicke der Schicht (1) entspricht.

4. Verfahren nach einem der Ansprüche 1 bis 3, **dadurch gekennzeichnet, dass** die Dicke d' der Schicht von der Energie der Röntgenphotonen, die absorbiert werden sollen, abhängt, und dass sie zwischen 100 µm und 1 mm liegt:

5. Verfahren nach einem der Ansprüche 1 bis 4, **dadurch gekennzeichnet, dass** das Reaktionsgas (6) H₂O unter Teildruck von mehreren hundert ppm ist.

6. Verfahren nach einem der Ansprüche 1 bis 5, **dadurch gekennzeichnet, dass** das Wachstum unter gereinigter Wasserstoffatmosphäre im Bereich von Atmosphärendruck stattfindet.

7. Gerät zur Herstellung eines elektronischen GaAs-Detektors zur Röntgenstrahlenerfassung und Bildaufnahme, umfassend:
- eine Kammer (14),
- k-Füsse (wobei k ≥ 3), wobei die Füße ein Stativ (15) bilden und die Kammer (14) gegenüber dem Rest des Gerätes thermisch isolieren,
- eine erste Platte (16), die auf dem Stativ (15) montiert ist und als Basis für den Rest des Gerätes dient,
- eine erste inerte Platte (17), die der thermischen Isolierung der Basis (16) für die Heizmittel dient,
- einen ersten Wafer (18), der einen Kanal (19) umfasst, um in diesem Temperaturmessmittel (20) unterzubringen,
- Heizmittel, die eine erste Heizeinrichtung (8) umfassen, die mit einem Strom (21) versorgt wird und ein Substrat n⁺ (oder p⁺) (2) auf eine Temperatur T₂ > 600 °C erhitzen,
- einen inerten Ring (10) mit einer Dicke d im Bereich von ein paar Millimetern, der das Substrat n⁺ (oder p⁺) (2) und ein Ausgangsmaterial (7) trennt und thermisch isoliert,
- eine zweite Heizeinrichtung (9), die mit Strom (22) versorgt wird und das Ausgangsmaterial (7) auf eine Temperatur T₁ > T₂ erhitzt,
- einen zweiten Wafer (23), der einen Kanal (24) umfasst, um in diesem Temperaturmessmittel (25) unterzubringen,
- eine zweite inerte Platte (26), die für die thermische Isolierung einer zweiten Platte (27) des Restes des .Gerätes dient.

8. Gerät nach Anspruch 7, **dadurch gekennzeichnet, dass** die Parallelität des Ausgangsmaterials (7) und des Substrats n⁺ (oder p⁺) (2) über 0,1 mm durch den inerten Ring (10) mit der Dicke d im Bereich von ein paar Millimetern gewährleistet wird.

9. Gerät nach Ansprüchen 7 und 8, **dadurch gekennzeichnet, dass** der inerte Ring (10) die gasförmige Permeabilität zwischen dem Raum, in dem die Reaktionen geschehen, und der Innenatmosphäre des Gerätes, gereinigtes H₂, das H₂O (6) enthält unter köntrolliertem Druck ermöglicht.

10. Gerät nach einem der Ansprüche 7 bis 9, **dadurch gekennzeichnet, dass** die Kammer (14) mittels einer Pumpe (28) evakuiert wird, bevor das gereinigte H₂ eingeführt wird und nach der Ablagerung der Epitaxieschicht, um die Produkte, die aus der Reaktion (6) abgeleitet sind, zu filtern.
